# EUROPEAN PATENT SPECIFICATION

(11) **EP 2 854 166 B1**
(45) Date of publication and mention of the grant of the patent: **29.06.2016**
(21) Application number: 13186396.1
(22) Date of filing: 27.09.2013
(51) Int. Cl.: H01L 21/677, B65G 49/06, B65H 3/06

(54) **APPARATUS FOR ALIGNING A SUBSTRATE**
Vorrichtung zum Ausrichten eines Substrats
Appareil pour l'alignement d'un substrat

(43) Date of publication of application: 01.04.2015
(73) Proprietor: APPLIED MATERIALS ITALIA S.R.L., 31048 San Biagio di Callalta (TV) (IT)
(72) Inventor: Pasqualin, Gianfranco, 31027 Spresiano (IT)
(74) Representative: Zimmermann & Partner Patentanwälte mbB

(56) References cited:
- JP-A- 2004 127 998
- JP-A- 2006 273 461
- US-A1- 2012 132 638

## Description

The present invention relates to an apparatus for aligning a substrate used to form photovoltaic (PV) cells, a solar cell production apparatus and a method for equipping a solar cell production apparatus with such an apparatus for aligning a substrate.

### BACKGROUND OF THE DISCLOSURE

Solar cells are PV devices that convert sunlight directly into electrical power. One major component in making commercially viable solar cells lies in reducing the manufacturing costs required to form the solar cells by improving the device yield and increasing the substrate throughput.

Some challenges in the field of production of photovoltaic cells are connected to the precise alignment of a substrate used to form photovoltaic (PV) cells. Particularly, the substrate may undergo a drying process in a drying oven and, after leaving said drying oven, it may be centered or aligned by means of an alignment device before performing for instance a screen printing process. JP 2004 127998 describes a substrate conveying apparatus having conveying rollers and shaft members rotating about an axis of rotation. A truncated-pyramidal roller is fixed to the shaft member. The conveying rollers convey the substrate along a transportation direction by supporting the substrate. JP 2006 273461 describes a conveyor for a wiring board. Guide rolls are attached to both ends of a roll axis. The guide rolls are positioned to contact a dummy region of the substrate. The guide roll is provided with a cone shaped guide part. US 2012/132638 relates to a work-piece transfer conveyor system. Fingers are secured to alternate links of transport system conveyance chains. The fingers include a support segment. Mounted on the support segment is a protective sleeve, and edges of a wafer make point contact with the surface of a plurality of the sleeves. The sleeves may be single conical.

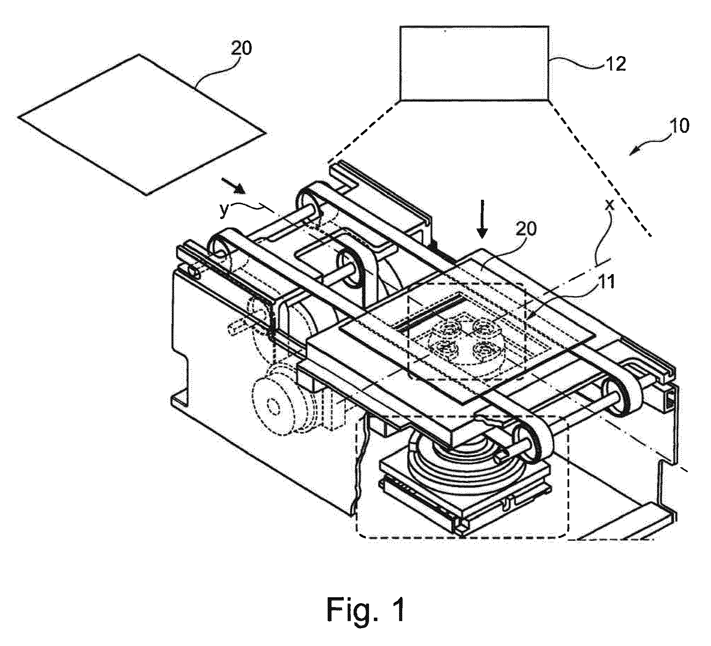

A currently used alignment device 10, as it is shown in FIG. 1, may be positioned at an end of the drying oven and may include a Bernoulli system 11 to grip the substrate 20, a camera 12 positioned at a top of the alignment device 10 to detect a position of the substrate 20, and a movement device 13 to translate and/or rotate the substrate 20. For alignment, the alignment device 10 may grip the substrate 20 leaving the oven by means of the Bernoulli gripper 11, detect a position of the substrate 20 using the camera 12, and may then adjust the position of the substrate 20 according to a reference position using the movement device 13.

However, such currently used alignment devices include complicated and expensive hardware. Particularly, such alignment devices require the presence of a vacuum system, a Bernoulli gripper, linear motors, an inspection system having a camera, etc. Accordingly, there is a need for an easy, less complicated and cost effective apparatus for aligning a substrate.

In view of the above, it is an object of the present invention to provide an apparatus for aligning a substrate, particularly an apparatus for aligning a substrate used to form photovoltaic (PV) cells, that overcome at least some of the problems in the art.

### SUMMARY OF THE INVENTION

In light of the above, an apparatus for aligning a substrate, a solar cell production apparatus, a method for equipping a solar cell production apparatus with such an apparatus for aligning a substrate, a method for retrofitting a solar cell production apparatus with such an apparatus for aligning a substrate, and a method for manufacturing a solar cell production apparatus are provided. Further aspects, advantages, and features of the present invention are apparent from the dependent claims, the description, and the accompanying drawings.

According to one embodiment, an apparatus for aligning a substrate used to form photofoltaic cells includes two or more conveying units, each conveying unit having two or more supporting elements configured to rotate about a first rotation axis to convey the substrate. Each supporting element includes one or more cone elements provided with a lateral surface configured to support the substrate. The two supporting elements of each conveying unit are arranged at a distance from each other along the first rotation axis. The distance at which the two supporting elements of one conveying unit are arranged from each other is greater than the distance at which the two supporting elements of one of the adjacent conveying units are arranged from each other.

According to one embodiment, a solar cell production apparatus includes one or more printing stations, and one or more apparatuses for aligning a substrate as described above.

According to one example, a method for equipping a solar cell production apparatus with an apparatus for aligning a substrate is provided. The method includes providing one or more printing stations, and providing one or more apparatuses for aligning a substrate as described above.

According to another example, a method for retrofitting a solar cell production apparatus including an alignment device having a Bernoulli system to grip the substrate and a camera configured to capture a position of the substrate is provided. The method includes replacing at least the Bernoulli system and the camera by the apparatus for aligning a substrate as described above.

According to another example, a method for manufacturing a solar cell production apparatus is provided. The method includes providing one or more printing stations, and providing one or more apparatuses for aligning a substrate as described above.

### BRIEF DESCRIPTION OF THE DRAWINGS

So that the manner in which the above recited features of the present disclosure can be understood in detail, a more particular description of the disclosure, briefly summarized above, may be had by reference to examples of the invention. The accompanying drawings relate to embodiments of the invention and are described in the following:
- FIG. 1: illustrates a state of the art alignment device used for alignment of substrates;
- FIG. 2: illustrates an apparatus for aligning a substrate;
- FIG. 3: illustrates an apparatus for aligning a substrate according to the invention;
- FIG. 4: shows a sectional view of an example of a supporting element of an apparatus for aligning a substrate;
- FIG. 5: shows a perspective view of the supporting element of FIG. 4;
- FIG. 6: shows another example of a supporting element of an apparatus for aligning a substrate;
- FIG. 7: shows still another example of a supporting element of an apparatus for aligning a substrate;
- FIG. 8: shows yet another example of a supporting element of an apparatus for aligning a substrate;
- FIG. 9: shows a further example of a supporting element of an apparatus for aligning a substrate;
- FIG. 10: shows another example of a supporting element of an apparatus for aligning a substrate;
- FIG. 11: shows a view of an apparatus for aligning a substrate;
- FIG. 12: shows a view of another apparatus for aligning a substrate;
- FIG. 13: shows a solar cell production apparatus having an apparatus for aligning a substrate;
and
- FIG. 14: shows a flowchart of a method for equipping a solar cell production apparatus with an apparatus for aligning a substrate.

### DETAILED DESCRIPTION OF EMBODIMENTS

Reference will now be made in detail to the various examples of the invention which are illustrated in the figures. Within the following description of the drawings, the same reference numbers refer to same components. Generally, the individual embodiments described are considered as examples of the invention Each example is provided by way of explanation of the invention and is not meant as a limitation of the invention.

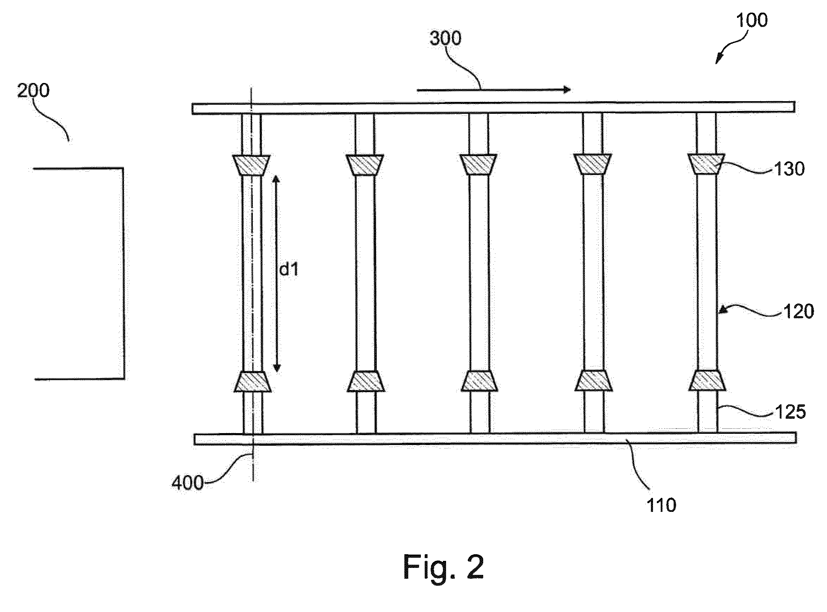

FIG. 2 illustrates an apparatus 100 for aligning a substrate 200 according to a first embodiment, which can be combined with other embodiments described herein.

According to some embodiments, the apparatus 100 for aligning a substrate 200 includes two or more conveying units 120. Each conveying unit 120 has two or more supporting elements 130 configured to rotate about a first rotation axis 400 of said supporting elements 130 to convey the substrate 200. Each supporting element 130 includes one or more cone elements. Each cone element is provided with a lateral surface configured to support the substrate 200. The lateral surface can also be referred to as circumferential surface.

By supporting the substrate 200 with the lateral surface of the cone element, stress or forces applied to the substrate during conveying are minimized. Particularly, by the inclined lateral surface of the cone element supporting the substrate or substrate edges/perimeter, force components acting perpendicular to a substrate surface are reduced. As a result, breakage of substrates, particularly of thin and/or large substrate, is reduced or even avoided. Thus, a throughput of substrates to be processed can be increased.

According to some embodiments, which could be combined with other embodiments described herein, each supporting element 130 includes one cone element. According to some other embodiments, which could be combined with other embodiments described herein, each supporting element 130 includes two cone elements. According to some embodiments, each cone element has a cone axis 153 substantially parallel to the first rotation axis 400 of the supporting element 130.

As shown in FIG. 2, the supporting elements 130 of each conveying unit 120 are arranged at a distance d1 from each other along the first rotation axis 400 of said supporting elements 130. The distance d1 could be substantially the same for all conveying units 120 of the apparatus 100, or could be different for at least some of the conveying units 120 of the apparatus 100. According to some embodiments, the distance d1 can be changed so as to be adapted to different wafer sizes.

According to some embodiments, the first rotation axis 400 is substantially perpendicular to a conveying direction 300 of the substrate 200. The term "substantially perpendicular" in this context shall include a deviation of up to 5° or even 10° from an 90° angle. According to some embodiments, the first rotation axes 400 associated with the conveying units 120 are substantially parallel to each other.

According to some embodiments, which could be combined with other embodiments described herein, each conveying unit 120 further includes a holding element 125. The holding element 125 is configured to hold or support the two or more supporting elements 130. Particularly, the supporting elements 130 of the conveying unit 120 are connected to the holding element 125. According to some embodiments, the connection is releasable for changing the first distance d1. According to some embodiments, the holding element 125 has a longitudinal axis substantially parallel to the first rotation axis 400 of the two or more supporting elements 130.

According to some embodiments, which could be combined with other embodiments described herein, each supporting element 130 has a through hole having an axis substantially parallel to the first rotation axis 400. The term "substantially parallel" in this context shall include a deviation of up to 5° or even 10° from a perfect parallel alignment. The holding element 125 of the conveying unit 120 may pass through the through holes of the two or more supporting elements 130 of said conveying unit 120 so as to hold or support the supporting elements 130.

According to some embodiments, the supporting elements 130 are fixedly attached to their respective holding element 125 so as to jointly rotate about the first rotation axis 400. Particularly, also the holding element 125 is configured to rotate about the first rotation axis 400. The supporting elements 130 are fixedly attached to the respective holding element 125 for instance by mechanical elements (e.g., screws), adhesives, soldering, welding, form locking or press fitting. When screws are provided for fixing, these screws could be configured to be loosened to allow a movement of the supporting element 130 with respect to the holding element 125 along the first rotation axis 400 for changing the distance d1.

According to some other embodiments, the holding elements 125 are fixed in position, i.e., they are non-rotatable, wherein the supporting elements 130 are provided moveable with respect to the holing element 125 so as to allow each supporting element 130 to rotate about the first rotation axis 400.

In the above case, according to some embodiments, each supporting element 130 is connected to its holding element 125 by means of a bearing, for instance a slide bearing or a roller bearing. The bearing may be a driven bearing so as to rotate the supporting elements 130 about the first rotation axis 400. Thereby, the substrate 200 supported by the supporting elements 130 can be conveyed in the conveying direction 300 substantially perpendicular to the first rotation axis 400 of the supporting elements 130. According to some embodiments, the bearing is provided moveable with respect to the holding element 125 along the first rotation axis 400 so as to allow a change of the distance d1.

According to some embodiments, which could be combined with other embodiments described herein, the holding elements 125 of the conveying units 120 are bar-shaped or rod-shaped each having a longitudinal axis. For instance, the longitudinal axes of the holding elements 125 could be arranged in parallel to each other. According to some embodiments, the longitudinal axes of the holding elements 125 are arranged substantially parallel to the first rotation axes 400.

According to some embodiments, which could be combined with other embodiments described herein, the apparatus 100 further includes a frame 110 provided for supporting the conveying units 120. For instance, the frame 110 is configured to hold one or more ends of the holding elements 125. When the holding elements are bar-shaped or rod-shaped each, the frame 110 could be configured to hold or support both ends of each bar-shaped or rod-shaped holding element 125.

As mentioned above, according to some embodiments, the holding elements 125 are fixed in position, i.e., they do not rotate. In this case, each holding element 125 could be fixedly attached to the frame 110. According to some embodiments, one or more ends of each holding element 125 could be fixedly attached to the frame 110, for instance by mechanical elements (e.g., screws), adhesives, soldering, welding, form locking or press fitting. In this case, the supporting elements 130 are configured to rotate about the first rotation axis 400.

According to some other embodiments, the supporting elements 130 are fixedly attached to their respective holding element 125 so as to jointly rotate about the first rotation axis 400. As an example, the holding elements 125 could be driven by a driving device, e.g., a motor, so as to rotate the holding elements 125, and thereby the supporting elements 130, about the first rotation axis 400.

According to some embodiments, which could be combined with other embodiments described herein, each holding element 125 is rotatable connected to the frame 110, for instance by means of a bearing. Bearings include, but are not limited to, a slide bearing and a roller bearing. According to some embodiments, the bearing may be a driven bearing so as to rotate the holding element 125, and thereby the supporting elements 130, about the first rotation axis 400. Thereby, the substrate 200 supported by the supporting elements 130 can be conveyed in a conveying direction 300 substantially perpendicular to the first rotation axis 400 of the supporting elements 130.

Each supporting element 130 includes a cone element having a cone axis 153 substantially parallel to the first rotation axis 400 of the supporting element 130. The cone element is configured to support the substrate 200 with its lateral surface. Thereby, stress or forces applied to the substrate 200 during conveying are minimized. Particularly, by the inclined lateral surface of the cone element supporting the substrate 200 or substrate edges, force components acting perpendicular to a substrate surface are reduced. As a result, damage or breakage of substrates, particularly of thin and/or large substrate, is reduced or even avoided. Thus, a throughput of substrates to be processed can be increased.

According to some embodiments, a diameter of each cone element decreases along the first rotation axis 400 of the supporting element 130. For instance, the diameter of each cone element decreases towards a center of the holing element 125. Thereby, only the substrate edges contact the supporting elements 130. As a result, force components acting perpendicular to a substrate surface are minimized and damage or breakage of the substrate is avoided.

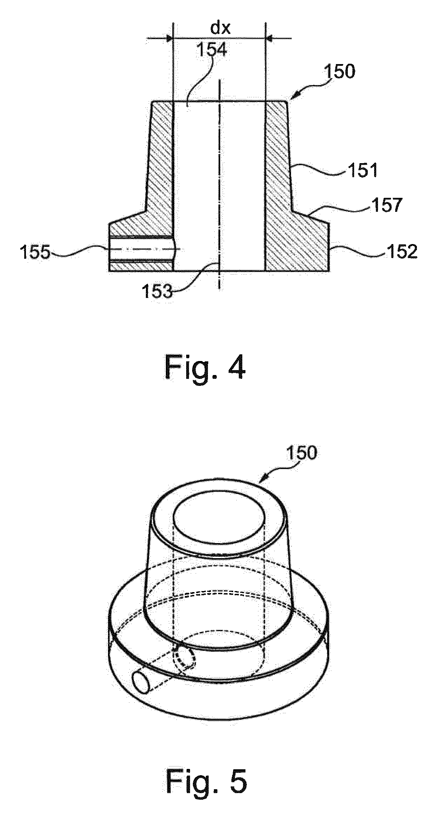

According to some embodiments, which could be combined with other embodiments described herein, the lateral surface of the cone element is inclined with respect to the cone axis 153. As an example, the lateral surface of the cone element has an angle in the range of 1° to 45°, 1° to 20°, or 5° to 10° with respect to the cone axis 153. According to some embodiments, which could be combined with other embodiments described herein, the cone element has two or more lateral surfaces each having a different angle with respect to the cone axis 153, or may be concavely or convexly shaped. These aspects will be described in more detail with reference to FIGs. 4 to 10.

According to some embodiments, which could be combined with other embodiments described herein, the supporting element 130 includes elastic material, for instance rubber. By providing the supporting element 130 with elastic material, the risk of damage to the substrate is even more reduced. According to some embodiments, which could be combined with other embodiments described herein, the supporting element 130 includes metal, for instance aluminum. According to some embodiments, which could be combined with other embodiments described herein, the supporting element 130 includes elastic material and metal. For instance, a metal body of the supporting element 130 could at least partially be covered with a layer of an elastic material. According to some embodiments, the lateral surface of the supporting element 150 is provided with a layer of an elastic material.

According to some embodiments, the supporting element 130 is made of a single piece. According to some other embodiments, the supporting element 130 consists of two or more pieces being made of the same or different materials. According to another example, only the portion of the supporting element 150 having the lateral surface could be made of metal or an elastic material.

According to some embodiments, each supporting element 130 of FIG. 2 could be implemented as any one of the supporting elements shown in FIGs. 4 to 10 and described later.

The present disclosure allows aligning substrates while they are moved in the conveying direction from one side of the apparatus for aligning a substrate to the other side. This shall be explained in view of the following example.

The substrates are supported by the supporting elements with a conical shaped lateral surface. Hence, if a substrate is misaligned, at least one edge of the substrate comes into contact with the supporting element close to or at the foot position of the cone. The foot position of a cone element shall be understood as the area with the largest diameter of the cone element. The top position of a cone element shall be understood as the area with the smallest diameter. Notably, the closer to the foot position a substrate edge comes in contact with a cone element, the higher the speed that is transferred to the substrate. Likewise, the closer to the top position a substrate edge comes in contact with a cone element, the smaller the speed that is transferred to the substrate. Consequently, if two opposite edges of the substrate, which are each supported by the conically shaped supporting elements, contact the respective supporting elements at different diameter positions, the substrate is pivoted in addition to the conveying movement in the conveying direction.

That is, if one edge of the substrate contacts the conical shaped supporting element closer to the foot position of the supporting element than the opposite edge of the substrate, which contacts another conical shaped supporting element, said edge is moved at a higher speed than the opposite edge. This leads to a pivoting movement wherein the pivoting movement aligns the substrate in such a manner that, in the end, both edges of the substrates are moved at the same speed. This is the case only if the substrates are completely aligned, i.e., if their edges are parallel to the conveying direction.

According to some embodiments, which could be combined with other embodiments described herein, the apparatus 100 for aligning a substrate 200 may further include one or more fans arranged in an area of the two or more conveying units. In this instance, "area of the two or more conveying units" may refer to a region close to said conveying units, and may particularly refer to an area above or below the conveying units. As an example, the one or more fans could be provided at a side of the two or more conveying units opposite the side where the substrate is supported. As an example, the one or more fans could be provided below the two or more conveying units.

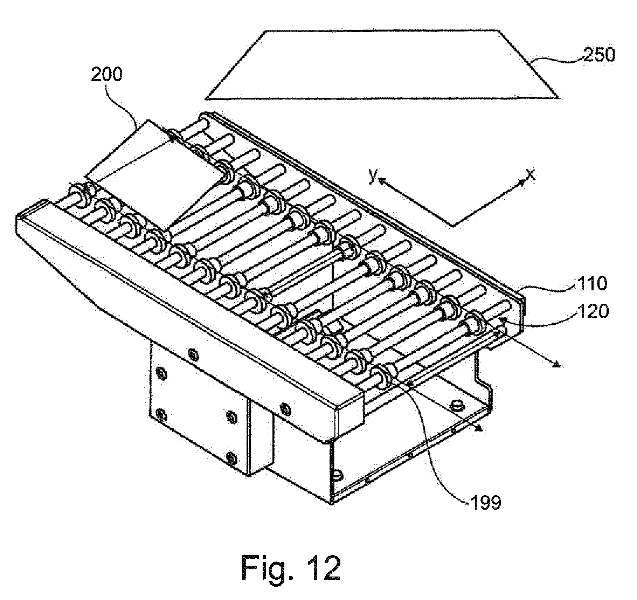

According to some embodiments, the one or more fans could be configured as suction units. According to some embodiments, the two or more fans may be configured to keep the substrate in contact with the supporting elements, e.g., for a better handling to avoid sliding phenomena. According to some embodiments, the two or more fans may be configured to extract or suck air blown by a cooling device, thereby giving more effectiveness on a heat removal action. As an example, the cooling device could be implemented as the cooling device 250 shown in FIG. 12 and described later.

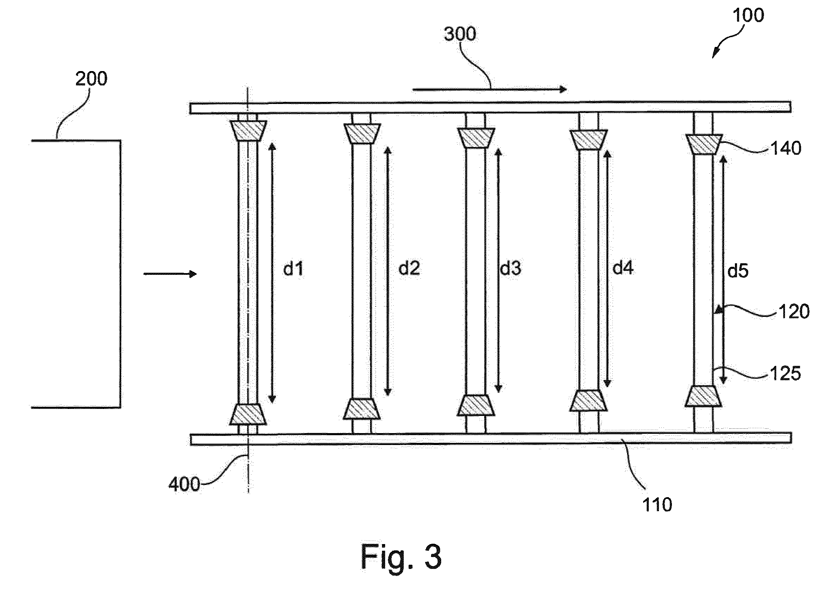

Turning now to FIG. 3, an apparatus 100 for aligning a substrate 200 according to a second embodiment is shown, which second embodiment could be combined with other embodiments described herein. The second embodiment could particularly be combined with the first embodiment shown in FIG. 2. Accordingly, a repetitive description of elements and features already described above with reference to FIG. 2 is omitted.

According to some embodiments, an apparatus 100 for aligning a substrate 200 includes two or more conveying units 120. Each conveying unit 120 has two or more supporting elements 140 configured to rotate about a first rotation axis 400 to convey the substrate 200. The two or more supporting elements 140 of each conveying unit 120 are arranged at a distance d1 to d5 from each other along the first rotation axis 400 of the respective supporting elements 140.

According to some embodiments, which could be combined with other embodiments described herein, the distance d1 to d5 at which the two supporting elements 140 of one conveying unit 120 are arranged from each other is greater than the distance d1 to d5 at which the two supporting elements 140 of one of the adjacent conveying units 120 are arranged from each other. In other words, the first distance d1 to d5 decreases from one conveying unit 120 to a next conveying unit 120 along a conveying direction 300 of the substrate 200. As an example, the conveying direction 300 of the substrate 200 is substantially perpendicular to the first rotation axis 400.

According to some embodiments, which could be combined with other embodiments described herein, the distance d1 to d5 changes along the conveying distance provided by the apparatus. According to some embodiments, the distance d1 (e.g., d1 in FIG. 3) at the beginning of the alignment apparatus is in the range of 100 to 200mm, 120 to 150mm, or 115 to 145mm, and the distance dx (e.g., d5 in FIG. 3) at the end of the alignment apparatus is 90 to 190mm, 115 to 145mm, or 110 to 140. According to some embodiments, the distance d1 to d5 changes in uniform steps of approximately 10mm, 5mm, 3mm, 2mm, 1mm, 0.5mm, 0.3mm or less from one convey unit 120 to a next or adjacent conveying unit 120. According to some embodiments, the distance d1 to d5 decreases in non-uniform steps from one convey unit 120 to a next or adjacent conveying unit 120.

According to some embodiments, the distances d1 to d5 can be changed so as to be adapted to different wafer sizes. As an example, each distance d1 to d5 could be changed in the range of 100mm to 5mm, and particularly in the range from 65 and 75mm, and more particularly approximately 70mm.

According to some embodiments, for changing the distances d1 to d5, a supporting element adjustment jig could be used. As an example, the supporting element adjustment jig could be arranged in a predetermined position (which may depend on the substrate size). Then the supporting elements could be brought in contact with said supporting element adjustment jig and then be fixed in position.

According to some embodiments, each supporting element 140 of FIG. 3 could be implemented as any one of the supporting elements shown in FIGs. 2 and 4 to 10.

According to some embodiments, which could be combined with other embodiments described herein, the substrate 200 is a large area substrate. Large area substrates may have a size of at least 0.174 m². Typically the size can be about 1.4 m² to about 8 m², more typically about 2 m² to about 9 m² or even up to 12 m². Typically, the substrates, for which the structures, apparatuses, such as cathode assemblies, and methods according to embodiments described herein are provided, are large area substrates as described herein. For instance, a large area substrate can be GEN 5, which corresponds to about 1.4 m² substrates (1.1 m x 1.3 m), GEN 7.5, which corresponds to about 4.29 m² substrates (1.95 m x 2.2 m), GEN 8.5, which corresponds to about 5.7m² substrates (2.2 m x 2.5 m), or even GEN 10, which corresponds to about 8.7 m² substrates (2.85 m x 3.05 m). Even larger generations such as GEN 11 and GEN 12 and corresponding substrate areas can similarly be implemented.

FIGs. 4 to 10 show examples of supporting elements that could be used in the embodiments of the apparatus for aligning a substrate described herein. The supporting elements of FIGs. 4 to 10 could particularly be used in the embodiments of FIGs. 2 and 3.

FIG. 4 shows a sectional view of an example of a supporting element 150 of an apparatus for aligning a substrate according to embodiments described herein. FIG. 5 shows a perspective view of the supporting element 150 of FIG. 4.

According to some embodiments, which can be combined with other embodiments described herein, the supporting element 150 includes a cone element having a first lateral surface 151 and a second lateral surface 152 separated by a step portion. The first lateral surface 151 is configured to support the substrate during conveying. The step portion provides a boundary 157 for the substrate being supported by the lateral surface 151 so as to guide the substrate. During normal operation or conveying, the substrate does not contact the boundary 157. The boundary 157 can have any suitable angle with respect to the cone axis 153, e.g., in the range of 45° to 135°, 70° to 110°, 80° to 100°, and particularly 90°.

According to some embodiments, the supporting element 150 includes a through hole 154, for instance for insertion of the holding element 125 shown in FIGs. 2 and 3. The through hole 154 has a diameter dx. For instance, the diameter dx is substantially the same as a diameter of the holding element.

According to some embodiments, a hole 155 is provided in the second lateral surface 152. The hole 155 has an axis substantially perpendicular to the cone axis 153 and extends to the through hole 154. According to some embodiments, the hole 155 is configured for insertion of a fixing element, for instance a screw, to engage the holding element being accommodated in the through hole 154. Thereby, the supporting element 150 can be fixedly attached to the holding element. According to some embodiments, the hole 154 is a threaded hole. Other techniques could also be used to fix the supporting element 150 to the holding element, for instance bearings, adhesives, soldering, welding, form locking or press fitting. When screws are provided for fixing, these screws could be configured to be loosened to allow a movement of the supporting element 150 with respect to the holding element 125 along the first rotation axis 400 for changing the distance d1 to d5.

According to some embodiments, which could be combined with other embodiments described herein, the supporting element 150 includes elastic material. By providing the supporting element 150 with elastic material, damage to the substrate can be avoided. According to some embodiments, which could be combined with other embodiments described herein, the supporting element 150 includes metal, for instance aluminum. According to some embodiments, which could be combined with other embodiments described herein, the supporting element 150 includes elastic material and metal. For instance, a metal body of the supporting element 150 could at least partially be covered with a layer of an elastic material. In another example, at least the first lateral surface 151 is provided with a layer of an elastic material.

According to some embodiments, the supporting element 150 is made of a single piece. According to some other embodiments, the supporting element 150 consists of two or more pieces being made of the same or different materials. According to another example, only the portion of the supporting element 150 having the first lateral surface 151 could be made of metal or elastic material.

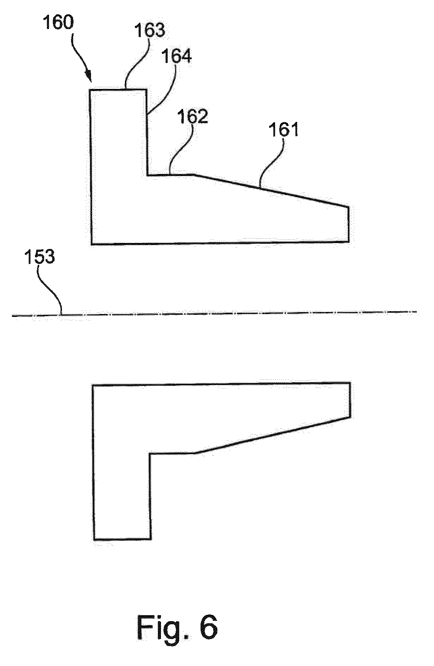

FIG. 6 shows another example of a supporting element 160 of an apparatus for aligning a substrate according to embodiments described herein.

According to some embodiments, which can be combined with other embodiments described herein, the supporting element 160 includes a cone element having a first lateral surface 161, a second lateral surface 162 and a third lateral surface 163. The second lateral surface 162 and the third lateral surface 163 are separated by a step portion. The first lateral surface 161 and optionally also the second lateral surface 162 are configured to support the substrate during conveying. The step portion provides a boundary 164 for the substrate being supported by the first and/or second lateral surfaces 161 and 162 so as to guide the substrate. During normal operation or conveying, the substrate does not contact the boundary 164. The boundary 164 can have any suitable angle with respect to the cone axis 153, e.g., in the range of 45° to 135°, 70° to 110°, 80° to 100°, and particularly 90°.

According to some embodiments, which could be combined with other embodiments described herein, the supporting element 160 includes a through hole, for instance for insertion of the holding element 125 shown in FIGs. 2 and 3. The through hole can be configured similarly to the through hole 154 described above with reference to FIGs. 4 and 5, and the description given above also applies to the supporting element 160 of FIG. 6.

According to some embodiments, the first lateral surface 161 of the cone element has angle with respect to the cone axis 153. As an example, the first lateral surface 161 of the cone element has an angle in the range of 1° to 45°, 1° to 20°, or 5° to 10° with respect to the cone axis 153. According to some embodiments, also the second lateral surface 162 of the cone element has angle with respect to the cone axis 153. Although FIG. 6 shows a case where the angle is substantially zero degrees, the angle could also be greater than zero degrees. For instance, the angle could be in the range of 0° to 45°, 0° to 20°, or 5° to 10°. According to some embodiments, the angle of the first lateral surface 161 with respect to the cone axis 153 is greater than the angle of the second lateral surface 162 with respect to said axis 153. According to some embodiments, at least one of the first and second lateral surfaces 161, 162 is concavely or convexly shaped. According to other embodiments, one of the first and second lateral surfaces 161, 162 is concavely shaped, the other one of the first and second lateral surfaces 161, 162 is convexly shaped.

According to some embodiments, a hole (not shown) for insertion of a fixing element as described above with reference to FIGs. 4 and 5 is provided in the third lateral surface 163. The hole can be configured similarly to the hole 155 described above with reference to FIGs. 4 and 5, and the description given above also applies to the supporting element 160 of FIG. 6.

According to some embodiments, which could be combined with other embodiments described herein, the supporting element 160 includes an elastic material. By providing the supporting element 160 with elastic material, damage to the substrate can be avoided. According to some embodiments, which could be combined with other embodiments described herein, the supporting element 160 includes metal, for instance aluminum. According to some embodiments, the supporting element 160 is made of a single piece. According to some other embodiments, the supporting element 160 consists of two or more pieces being made of the same or different materials. For instance, only the portion having the first and second lateral surfaces 161 and 162 could be made of metal or elastic material. In another example, at least one of the first lateral surface 161 and the second lateral surface 162 is provided with a layer of an elastic material. For instance, a metal body of the supporting element 160 could at least partially be covered with a layer of an elastic material. In another example, at least the first lateral surface 161 is provided with a layer of an elastic material.

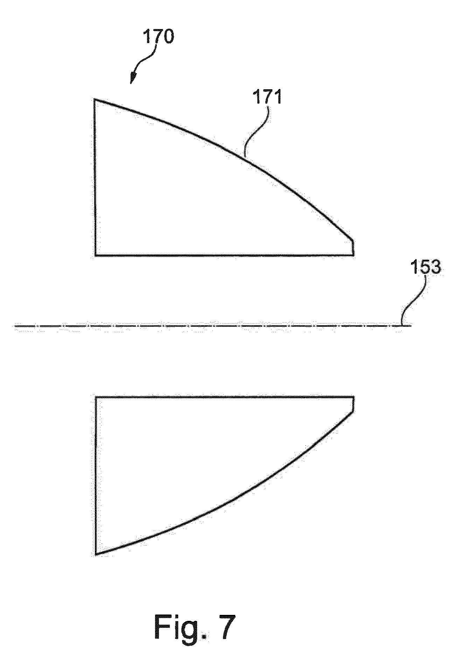

FIG. 7 shows still another example of a supporting element 170 of an apparatus for aligning a substrate according to embodiments described herein.

According to some embodiments, which can be combined with other embodiments described herein, the supporting element 170 includes a cone element having a convexly shaped lateral surface 171.

According to some embodiments, which could be combined with other embodiments described herein, the supporting element 170 includes a through hole, for instance for insertion of the holding element 125 shown in FIGs. 2 and 3. The through hole can be configured similarly to the through hole 154 described above with reference to FIGs. 4 and 5, and the description given above also applies to the supporting element 170 of FIG. 7.

According to some embodiments, a hole (not shown) for insertion of a fixing element as described above with reference to FIGs. 4 and 5 is provided in the convexly shaped lateral surface 171. The hole can be configured similarly to the hole 155 described above with reference to FIGs. 4 and 5, and the description given above also applies to the supporting element 170 of FIG. 7.

According to some embodiments, which could be combined with other embodiments described herein, the supporting element 170 includes an elastic material. By providing the supporting element 170 with elastic material, damage to the substrate can be avoided. According to some embodiments, which could be combined with other embodiments described herein, the supporting element 170 includes metal, for instance aluminum. According to some embodiments, the supporting element 170 is made of a single piece. According to some other embodiments, the supporting element 170 consists of two or more pieces being made of the same or different materials. In another example, the lateral surface 171 is provided with a layer of elastic material. For instance, a metal body of the supporting element 170 could at least partially be covered with a layer of an elastic material. In another example, at least the lateral surface 171 is provided with a layer of an elastic material.

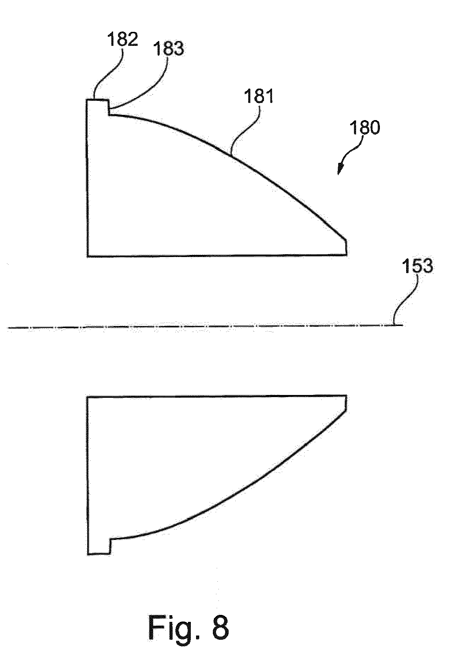

FIG. 8 shows yet another example of a supporting element 180 of an apparatus for aligning a substrate according to embodiments described herein. The supporting element 180 illustrated in FIG. 8 is similar to the supporting element shown in FIG. 7, and the above given description also applies to said supporting element 180.

According to some embodiments, which can be combined with other embodiments described herein, the supporting element 180 includes a cone element having a convexly shaped first lateral surface 181 and a second lateral surface 182. According to some embodiments, the second lateral surface 182 is a plane surface. The first lateral surface 181 and the second lateral surface 183 are separated by a step portion. The step portion provides a boundary 183 for the substrate being supported by the first lateral surfaces 181 so as to guide the substrate. During normal operation or conveying, the substrate does not contact the boundary 183.

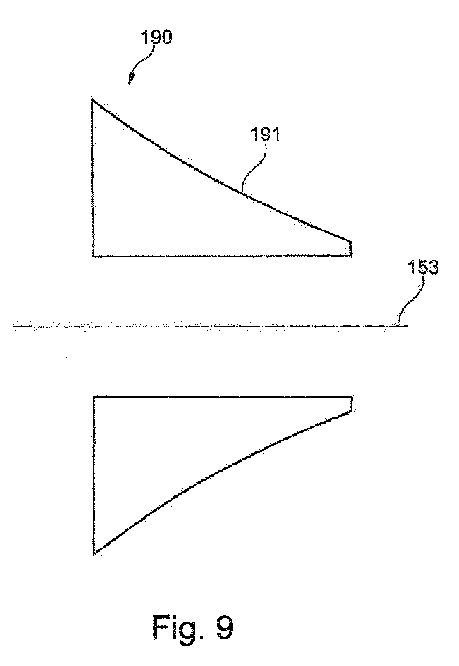

FIG. 9 shows a further example of a supporting element 190 of an apparatus for aligning a substrate according to embodiments described herein.

According to some embodiments, which can be combined with other embodiments described herein, the supporting element 190 includes a cone element having a concavely shaped lateral surface 191.

According to some embodiments, which could be combined with other embodiments described herein, the supporting element 191 includes a through hole, for instance for insertion of the holding element 125 shown in FIGs. 2 and 3. The through hole can be configured similarly to the through hole 154 described above with reference to FIGs. 4 and 5, and the description given above also applies to the supporting element 170 of FIG. 9.

According to some embodiments, a hole (not shown) for insertion of a fixing element as described above with reference to FIGs. 4 and 5 is provided in the concavely shaped lateral surface 191. The hole can be configured similarly to the hole 155 described above with reference to FIGs. 4 and 5, and the description given above also applies to the supporting element 190 of FIG. 9.

According to some embodiments, which could be combined with other embodiments described herein, the supporting element 190 includes an elastic material. By providing the supporting element 190 with elastic material, damage to the substrate can be avoided. According to some embodiments, which could be combined with other embodiments described herein, the supporting element 190 includes metal, for instance aluminum. According to some embodiments, the supporting element 190 is made of a single piece. According to some other embodiments, the supporting element 190 consists of two or more pieces being made of the same or different materials. In another example, the lateral surface 191 is at least partially provided with a layer of an elastic material. For instance, a metal body of the supporting element 190 could at least partially be covered with a layer of an elastic material. In another example, at least the lateral surface 191 is provided with a layer of an elastic material.

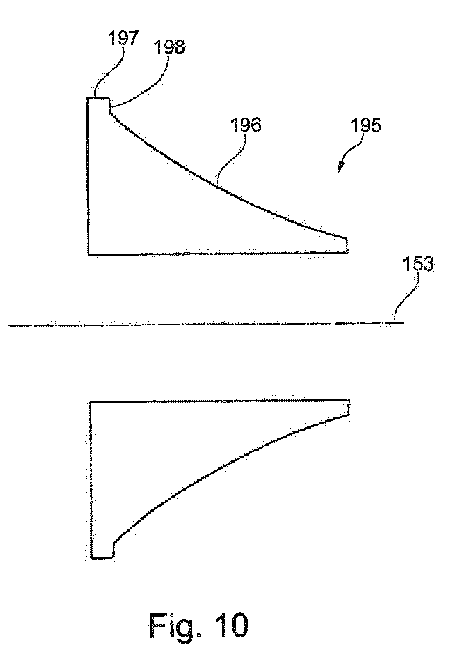

FIG. 10 shows another example of a supporting element 195 of an apparatus for aligning a substrate according to embodiments described herein. The supporting element 195 illustrated in FIG. 10 is similar to the supporting element shown in FIG. 9, and the above given description also applies to said supporting element 195.

According to some embodiments, which can be combined with other embodiments described herein, the supporting element 195 includes a cone element having a concavely shaped first lateral surface 196 and a second lateral surface 197. According to some embodiments, the second lateral surface 197 is a plane surface. The first lateral surface 196 and the second lateral surface 197 are separated by a step portion. The step portion provides a boundary 198 for the substrate being supported by the first lateral surface 196 so as to guide the substrate. During normal operation or conveying, the substrate does not contact the boundary 198.

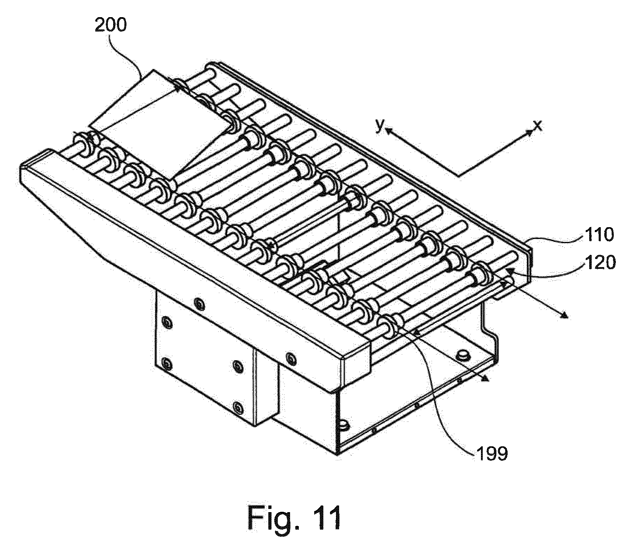

Turning now to FIG. 11, a perspective view of an apparatus for aligning a substrate according to embodiments described herein is shown.

The apparatus 100 for aligning a substrate 200 includes the two or more conveying units 120. Each conveying unit 120 has two or more supporting elements 130 configured to rotate about a first rotation axis 400 to convey the substrate 200. Each supporting element 199 includes a cone element having a cone axis substantially parallel to the first rotation axis (indicated as x-axis). The cone element is provided with a lateral surface configured to support the substrate 200.

According to some embodiments, each conveying unit 120 of FIG. 11 could be implemented as any one of the conveying units described above with reference to FIGs. 2 and 3. Particularly, each supporting element 199 of FIG. 11 could be implemented as any one of the supporting elements described above with reference to FIGs. 2 to 10.

FIG. 12 is a perspective view of another apparatus for aligning a substrate according to embodiments described herein. The apparatus is similar to the apparatus shown in FIG. 12, the difference being that additionally a cooling device 250 is provided above of at least some of the conveying units 120. Referring to FIG. 1, the drying oven could push the temp of the substrate for instance above 300 °C. At this point it could be important to cool down the temperature of the substrate or wafer to avoid hardware damage and also to prevent process issues.

According to some embodiments, the cooling device 250 is configured to cool down the substrate, e.g., after leaving a drying oven,. According to some embodiments, the cooling is simultaneously performed with the alignment process carried out by the apparatus of the embodiments described herein.

Referring again to FIG. 1, a state of the art alignment device 10 is positioned at an end of a drying oven performing a drying process. A camera positioned above the substrate position is used in the subsequent alignment process. The present embodiments do not require any camera positioned above the substrate, since alignment is solely achieved by the conveying units used to convey the substrate. Accordingly, space above the substrate position is available for providing the cooling device 250 right there. This has the particular beneficial effect that the cooling process and the alignment process can be performed simultaneously during one single process step, whereby processing time, costs and complexity of a processing system can be reduced.

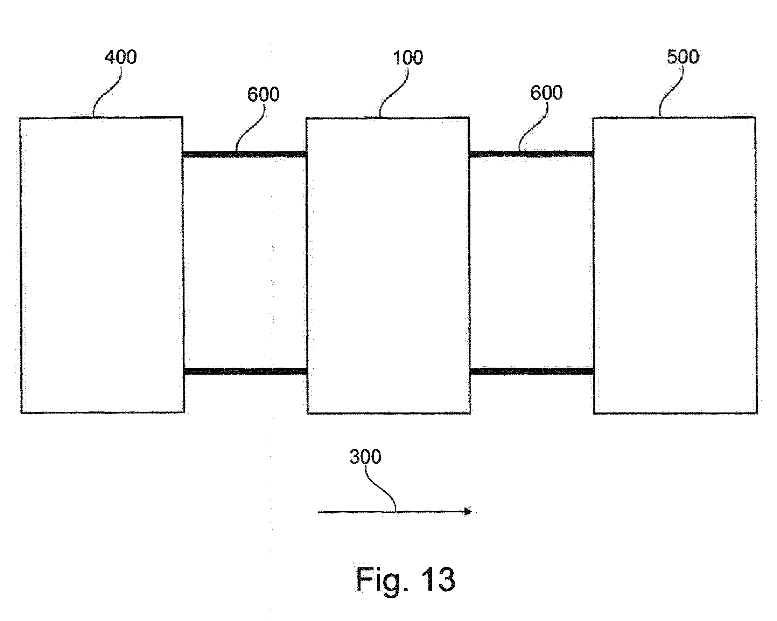

FIG. 13 shows a solar cell production apparatus having an apparatus for aligning a substrate according to embodiments described herein.

According to one embodiment, a solar cell production apparatus includes, but is not limited to, one or more printing stations 500, one or more cooling stations 400 and/or one or more apparatuses 100 for aligning a substrate as described herein. In the example illustrated in FIG. 13, the solar cell production apparatus includes three stations arranged along the conveying direction 300 of the substrate. The solar cell production apparatus is not limited to the example having three stations, and could particularly include four or more stations arranged in any suitable order. In FIG. 13, a cooling station 400, an alignment station having an apparatus 100 for aligning a substrate as described herein, and a printing station 500 are sequentially arranged along the conveying direction 300. The stations may be connected by means of conveyors 600, e.g., a conveyor belt, for transferring the substrate from one station to another station. However, conveyors 600 may be dispensable or be replaced by one or more alignment stations that also serve to convey the wafers.

According to some embodiments, the cooling station 400 and the apparatus 100 are implemented as one single station, as it is described above with reference to FIG. 12.

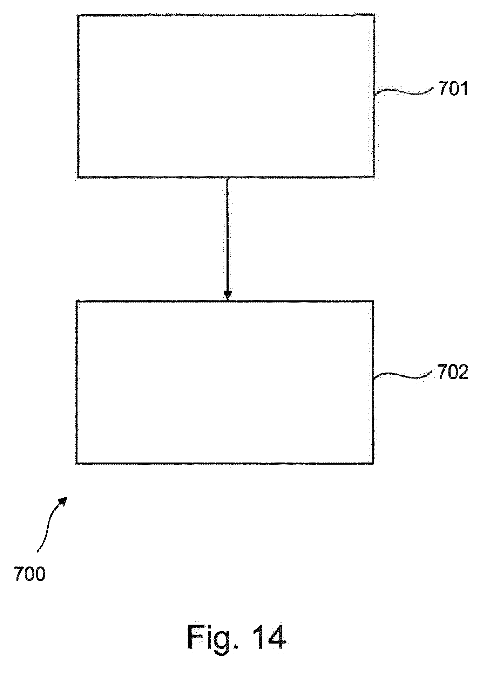

FIG. 14 shows a flowchart of a method for equipping a solar cell production apparatus with an apparatus for aligning a substrate according to embodiments described herein.

According to one embodiment, method 700 for equipping a solar cell production apparatus with an apparatus for aligning a substrate includes providing one or more printing stations (block 701), and providing one or more apparatuses for aligning a substrate as described above (block 702).

According to another embodiment, a method for retrofitting a solar cell production apparatus including an alignment device having a Bernoulli system to grip the substrate and a camera configured to capture a position of the substrate includes replacing at least the Bernoulli system and the camera by the apparatus for aligning a substrate as described above.

According to another embodiment, a method for manufacturing a solar cell production apparatus includes providing one or more printing stations, and providing one or more apparatuses for aligning a substrate as described above.

The present disclosure provides an apparatus for aligning a substrate that has less complicated and cost-effective hardware. Particularly, the apparatus for aligning a substrate according to the present embodiments does not require any camera positioned above the substrate, since alignment is solely achieved by the conveying units used to convey the substrate. Accordingly, space above the substrate position is available, e.g., for providing a cooling device. This has the particular beneficial effect that the cooling process and the alignment process can be performed simultaneously during one single process step, whereby processing time, costs and complexity of a processing system can be reduced.

## Claims

1. An apparatus (100) for aligning a substrate (200) used to form photovoltaic cells comprising:
two or more conveying units (120), each conveying unit (120) comprising two supporting elements (130, 140, 150, 160, 170, 180, 190, 195, 199) configured to rotate about a first rotation axis (400) to convey the substrate (200),
wherein each supporting element (130, 140, 150, 160, 170, 180, 190, 195, 199) comprises one or more cone elements provided with a lateral surface (151; 161, 162; 171; 181; 191; 196) configured to support the substrate (200),
wherein the two supporting elements (130, 140, 150, 160, 170, 180, 190, 195, 199) of each conveying unit (120) are arranged at a distance (d1-d5) from each other along the first rotation axis (400), and
**characterized in that** the distance (d1-d5) at which the two supporting elements (130, 140, 150, 160, 170, 180, 190, 195, 199) of one conveying unit (120) are arranged from each other is greater than the distance (d1-d5) at which the two supporting elements (130, 140, 150, 160, 170, 180, 190, 195, 199) of one of the adjacent conveying units (120) are arranged from each other.

2. The apparatus (100) of claim 1, wherein the lateral surface (151, 161) of the cone element has angle of 1° to 20° with respect to a cone axis (153) of said cone element, in particular 5° to 15°.

3. The apparatus (100) of claim 1 or 2, wherein the cone element has two or more lateral surfaces (161, 162) having different angles with respect to the cone axis (153).

4. The apparatus (100) of one of claims 1 to 3, wherein each conveying unit (120) further includes a holding element (125) configured to hold the supporting elements (130), wherein the holding elements (125) of the two conveying units (120) are preferably bar-shaped or rod-shaped.

5. The apparatus (100) of one of claims 1 to 4, wherein each holding element (125) is configured to rotate about the first rotation axis (400).

6. The apparatus (100) of claim 5, wherein the supporting elements (130, 140, 150, 160, 170, 180, 190, 195, 199) are fixedly attached to the holding element (125).

7. The apparatus (100) of one of claims 1 to 4, wherein the supporting elements (130, 140, 150, 160, 170, 180, 190, 195, 199) are rotatable attached to the holding element (125).

8. The apparatus (100) of one of claims 1 to 7, wherein each supporting element (130, 140, 150, 160, 170, 180, 190, 195, 199) has a through hole (154) having an axis parallel to the first rotation axis (400), and the holding element (125) optionally passes through the through hole (154).

9. The apparatus (100) of one of claims 1 to 8, wherein the cone element includes metal or elastic material or is coated with the elastic material.

10. The apparatus (100) for aligning a substrate (200) of one of claims 1 to 9, further including a cooling device (250) arranged above at least one of two or more conveying units (120).

11. The apparatus (100) for aligning a substrate (200) of one of claims 1 to 10, further including one or more fans arranged in an area of the two or more conveying units (120), wherein the one or more fans are preferably provided below the two or more conveying units (120).

12. A solar cell production apparatus, comprising:
one or more printing stations (500), and
one or more apparatuses (100) for aligning a substrate (200) according to one of claims 1 to 11.

13. A method (700) for equipping a solar cell production apparatus with an apparatus for aligning a substrate, the method including:
providing (701) one or more printing stations; and
providing (702) one or more apparatuses (100) for aligning a substrate (200) according to one of claims 1 to 11.

## Patentansprüche

1. Eine Vorrichtung (100) zum Ausrichten eines Substrates (200), das zur Bildung von photovoltaischen Zellen benutzt wird, umfassend:
zwei oder mehr Beförderungseinheiten (120), wobei jede Beförderungseinheit (120) zwei Auflageelemente (130, 140, 150, 160, 170, 180, 190, 195, 199) umfasst, die zum Rotieren um eine erste Rotationsachse (400) ausgelegt sind, um das Substrat (200) zu befördern,
wobei jedes Auflageelement (130, 140, 150, 160, 170, 180, 190, 195, 199) ein oder mehrere Kegelelemente umfasst, die mit einer seitlichen Fläche (151; 161, 162; 171; 181; 191; 196) ausgestattet sind, die ausgelegt ist, das Substrat (200) zu tragen,
wobei die zwei Auflageelemente (130, 140, 150, 160, 170, 180, 190, 195, 199) von jeder Beförderungseinheit (120) in einem Abstand (d1-d5) voneinander entlang der ersten Rotationsachse (400) angeordnet sind,
**dadurch gekennzeichnet, dass**
der Abstand (d1-d5), in dem die zwei Auflageelemente (130, 140, 150, 160, 170, 180, 190, 195, 199) einer Beförderungseinheit (120) voneinander angeordnet sind, größer ist als der Abstand (d1-d5), in dem die zwei Auflageelemente (130, 140, 150, 160, 170, 180, 190, 195, 199) einer der benachbarten Beförderungseinheiten voneinander angeordnet sind.

2. Die Vorrichtung (100) gemäß Anspruch 1, wobei die seitliche Oberfläche (151, 161) des Kegelelements einen Winkel von zwischen 1 und 20° in Bezug auf die Kegelachse (153) des Kegelelements aufweist, insbesondere 5° bist 15°.

3. Die Vorrichtung (100) gemäß Anspruch 1 oder 2, wobei das Kegelelement zwei oder mehr seitliche Oberflächen (161, 162) aufweist, die unterschiedliche Winkel in Bezug auf die Kegelachse (153) haben.

4. Die Vorrichtung (100) gemäß einem der Ansprüche 1 bis 3, wobei jedes Beförderungselement (120) des Weiteren ein Halteelement (125) umfasst, das ausgelegt ist, um die Auflageelemente (130) zu halten, wobei die Halteelemente (125) der zwei Beförderungseinheiten (120) vorzugsweise stab- oder stangenförmig sind.

5. Die Vorrichtung (100) gemäß einem der Ansprüche 1 bis 4, wobei jedes Halteelement (125) ausgerichtet ist, um die erste Rotationsachse (400) zu rotieren.

6. Die Vorrichtung (100) gemäß Anspruch 5, wobei die Auflageelemente (130, 140, 150, 160, 170, 180, 190, 195, 199) fest an den Halteelementen (125) angebracht sind.

7. Die Vorrichtung (100) gemäß einem der Ansprüche 1 bis 4, wobei die Auflageelemente (130, 140, 150, 160, 170, 180, 190, 195, 199) rotierbar an den Halteelementen (125) angebracht sind.

8. Die Vorrichtung (100) gemäß einem der Ansprüche 1 bis 7, wobei jedes Auflageelement (130, 140, 150, 160, 170, 180, 190, 195, 199) ein Durchgangsloch (154) mit einer Achse parallel zu der ersten Rotationsachse (400) aufweist, und sich das Halteelement (125) optional durch das Durchgangsloch (154) durch erstreckt.

9. Die Vorrichtung (100) gemäß einem der Ansprüche 1 bis 8, wobei das Kegelelement ein metallisches oder elastisches Material umfasst, oder mit dem elastischen Material beschichtet ist.

10. Die Vorrichtung (100) zum Ausrichten eines Substrats (200) gemäß einem der Ansprüche 1 bis 9, des Weiteren umfassend eine Kühleinrichtung (250), die oberhalb wenigstens eines der ein oder mehreren Beförderungseinheiten (120) angeordnet ist.

11. Die Vorrichtung (100) zum Ausrichten eines Substrats (200) gemäß einem der Ansprüche 1 bis 10, des Weiteren umfassend eine oder mehrere Lüfter, die in der Gegend der zwei oder mehr Beförderungseinheiten (120) angeordnet sind, wobei die ein oder mehreren Belüfter vorzugsweise unterhalb der zwei oder mehr Beförderungseinheiten (120) angeordnet sind.

12. Eine Solarzellenherstellungsvorrichtung, umfassend:
eine oder mehrere Druckstationen (500), und
einen oder mehrere Vorrichtungen (100) zum Ausrichten eines Substrats (200) gemäß einem der Ansprüche 1 bis 11).

13. Ein Verfahren (700) zum Ausstatten einer Solarzellenherstellungsvorrichtung mit einer Vorrichtung zum Ausrichten eines Substrats, wobei das Verfahren umfasst:
zur Verfügung Stellen (701) einer oder mehrerer Druckstationen; und
zur Verfügung Stellen (702) einer oder mehrerer Vorrichtungen (100) zum Ausrichten eines Substrats (200) gemäß einem der Ansprüche 1 bis 11.

## Revendications

1. Appareil (100) destiné à aligner un substrat (200) utilisé pour former des cellules photovoltaïques comprenant :
deux ou plus unités de convoyage (120), chaque unité de convoyage (120) comprenant deux éléments supports (130, 140, 150, 160, 170, 180, 190, 195, 199) configurés pour tourner autour d'un premier axe de rotation (400) pour convoyer le substrat (200),
sachant que chaque élément support (130, 140, 150, 160, 170, 180, 190, 195, 199) comprend un ou plusieurs éléments coniques dotés d'une surface latérale (151 ; 161, 162 ; 171 ; 181 ; 191 ; 196) configurée pour supporter le substrat (200),
sachant que les deux éléments supports (130, 140, 150, 160, 170, 180, 190, 195, 199) de chaque unité de convoyage (120) sont agencés à une distance (d1-d5) l'un de l'autre le long du premier axe de rotation (400), et
**caractérisé en ce que**
la distance (d1-d5) à laquelle les deux éléments supports (130, 140, 150, 160, 170, 180, 190, 195, 199) d'une unité de convoyage (120) sont agencés l'un de l'autre est plus grande que la distance (d1-d5) à laquelle les deux éléments supports (130, 140, 150, 160, 170, 180, 190, 195, 199) d'une des unités de convoyage (120) adjacentes sont agencés l'un de l'autre.

2. L'appareil (100) de la revendication 1, sachant que la surface latérale (151, 161) de l'élément conique a un angle de 1° à 20° par rapport à un axe de cône (153) dudit élément conique, en particulier de 5° à 15°.

3. L'appareil (100) de la revendication 1 ou 2, sachant que l'élément conique présente deux ou plus surfaces latérales (161, 162) ayant des angles différents par rapport à l'axe de cône (153).

4. L'appareil (100) de l'une des revendications 1 à 3, sachant que chaque unité de convoyage (120) inclut en outre un élément de maintien (125) configuré pour maintenir les éléments supports (130), sachant que les éléments de maintien (125) des deux unités de convoyage (120) sont de préférence en forme de barre ou en forme de tige.

5. L'appareil (100) de l'une des revendications 1 à 4, sachant que chaque élément de maintien (125) est configuré pour tourner autour du premier axe de rotation (400).

6. L'appareil (100) de la revendication 5, sachant que les éléments supports (130, 140, 150, 160, 170, 180, 190, 195, 199) sont attachés de manière fixe à l'élément de maintien (125).

7. L'appareil (100) de l'une des revendications 1 à 4, sachant que les éléments supports (130, 140, 150, 160, 170, 180, 190, 195, 199) sont attachés de manière tournante à l'élément de maintien (125).

8. L'appareil (100) de l'une des revendications 1 à 7, sachant que chaque élément support (130, 140, 150, 160, 170, 180, 190, 195, 199) présente un trou traversant (154) ayant un axe parallèle au premier axe de rotation (400), et l'élément de maintien (125) passe facultativement à travers le trou traversant (154).

9. L'appareil (100) de l'une des revendications 1 à 8, sachant que l'élément conique inclut un matériau métallique ou élastique ou est revêtu du matériau élastique.

10. L'appareil (100) destiné à aligner un substrat (200) de l'une des revendications 1 à 9, incluant en outre un dispositif de refroidissement (250) agencé au-dessus d'au moins une de deux ou plus unités de convoyage (120).

11. L'appareil (100) destiné à aligner un substrat (200) de l'une des revendications 1 à 10, incluant en outre un ou plusieurs ventilateurs agencés dans une zone des deux ou plus unités de convoyage (120), sachant que l'un ou les plusieurs ventilateurs sont de préférence disposés en-dessous des deux ou plus unités de convoyage (120).

12. Appareil de production de cellules solaires, comprenant :
une ou plusieurs stations d'impression (500), et
un ou plusieurs appareils (100) destinés à aligner un substrat (200) selon l'une des revendications 1 à 11.

13. Procédé (700) destiné à équiper un appareil de production de cellules solaires d'un appareil destiné à aligner un substrat, le procédé incluant :
la fourniture (701) d'une ou de plusieurs stations d'impression ; et
la fourniture (702) d'un ou de plusieurs appareils (100) destinés à aligner un substrat (200) selon l'une des revendications 1 à 11.
